# EUROPEAN PATENT APPLICATION

(11) **EP 2 105 973 A1**
(43) Date of publication of application: **30.09.2009**
(21) Application number: 08703200.9
(22) Date of filing: 15.01.2008
(51) Int. Cl.: H01L 33/00, C23C 14/06, C23C 16/34, H01L 21/203, H01S 5/323, H01L 21/205

(54) **III NITRIDE COMPOUND SEMICONDUCTOR ELEMENT AND METHOD FOR MANUFACTURING THE SAME, III NITRIDE COMPOUND SEMICONDUCTOR LIGHT EMITTING ELEMENT AND METHOD FOR MANUFACTURING THE SAME, AND LAMP**

(30) Priority: 16.01.2007 JP 2007006790; 13.07.2007 JP 2007184456; 22.10.2007 JP 2007274458; 02.11.2007 JP 2007286691
(71) Applicant: Showa Denko K.K., Tokyo 105-8518 (JP)
(72) Inventor: KAJI, Hiroaki, Ichihara-shi Chiba 290-0067 (JP); YOKOYAMA, Yasunori, Ichihara-shi Chiba 290-0067 (JP); SAKAI, Hiromitsu, Ichihara-shi Chiba 290-0067 (JP)
(74) Representative: Strehl Schübel-Hopf & Partner
(86) International application number: PCT/JP2008/050336
(87) International publication number: WO 2008/087930

(57) **Abstract**

A group-III nitride compound semiconductor device of the present invention comprises a substrate, an intermediate layer provided on the substrate, and a base layer provided on the intermediate layer in which a full width at half maximum in rocking curve of a (0002) plane is 100 arcsec or lower and a full width at half maximum in rocking curve of a (10-10) plane is 300 arcsec or lower. Also, a production method of a group-III nitride compound semiconductor device of the present invention comprises forming the intermediate layer by using a sputtering method.

## Description

### TECHNICAL FIELD

The present invention relates to a group-III nitride compound semiconductor device that can be used favorably in a light-emitting diode (LED), a laser diode (LD) or an electronic device or the like, and a production method of such a semiconductor device, a group-III nitride compound semiconductor light-emitting device and a production method thereof, and a lamp that uses a group-III nitride compound semiconductor light-emitting device.

### BACKGROUND ART

A group-III nitride compound semiconductor is a direct transition-type semiconductor which, for example, when used as a light-emitting device, has an emission spectrum that extends across a broad range from ultraviolet to red. These group-III nitride compound semiconductors are used for light-emitting devices such as light-emitting diodes (LED) and laser diodes (LD). Because these types of light-emitting devices have a higher light emission efficiency than conventional illumination devices, their energy consumption is lower. Further, these types of light-emitting devices also offer other advantages such as long life, and the market for such devices is expanding rapidly.

A group-III nitride compound semiconductor is typically formed on top of a sapphire substrate. However, when a group-III nitride compound semiconductor is formed on a sapphire substrate, lattice constant misfit between the sapphire and the group-III nitride compound semiconductor causes dislocation, which has an adverse effect on the device properties. Dislocation caused by this type of misfit is threading dislocation that penetrates through the longitudinal direction (the direction perpendicular to the substrate surface) of the semiconductor layer. Threading dislocation within the semiconductor layer of a light-emitting device causes a variety of phenomena, including scattering of the electrons that leads to reduced electron mobility, and the generation of a leakage current. Accordingly, threading dislocation within the semiconductor layer of a light-emitting device causes a reduction in the light emission efficiency of the light-emitting device, resulting in reduced emission intensity.

Conventionally, in order to suppress misfit, the group-III nitride compound semiconductor has been grown on the substrate with an intermediate layer disposed therebetween (for example, see Japanese Patent No. 3,026,087 and Japanese Unexamined Patent Application, First Publication No. Hei 4-297023). The intermediate layer is formed by using a metal-organic chemical vapor deposition method (MOCVD method) to deposit a GaN film with the same composition as the group-III nitride compound semiconductor or an AlN film of the same wurtzite structure.

However, even when a group-III nitride compound semiconductor is grown on a substrate with an intermediated layer disposed therebetween, threading dislocation within the semiconductor layer cannot be prevented entirely satisfactorily, and there is considerable demand for semiconductor layers having an even lower level of threading dislocation.

### DISCLOSURE OF INVENTION

The present invention takes the above circumstances into consideration, with an object of providing a group-III nitride compound semiconductor light-emitting device that exhibits minimal threading dislocation within the semiconductor layer and yields superior light emission properties.
Further, another object is to provide a production method of a group-III nitride compound semiconductor light-emitting device that exhibits minimal threading dislocation within the semiconductor layer and has superior light emission properties.
Furthermore, yet another object is to provide a lamp that uses the above group-III nitride compound semiconductor light-emitting device.

In order to achieve the above objects, the inventors of the present invention undertook intensive research, investigating the relationship between threading dislocation and the light emission properties of the light-emitting device.
One possible method of detecting threading dislocation within the semiconductor layer involves inspecting a cross-section of the sample using a transmission electron microscope (TEM). However, the results of evaluating threading dislocation obtained by TEM observation only represent the results of evaluating the threading dislocation within a certain limited area, and whether these results are representative of the entire semiconductor layer is open to debate. Further, in order to enable observation of threading dislocation using a TEM, the sample must be processed, meaning the sample used for observation cannot be used as a device. As a result, a problem arises in that the threading dislocation evaluation results and the device properties cannot be correlated precisely.

Accordingly, the inventors of the present invention investigated the use of nondestructive methods of evaluating threading dislocation as potential methods for detecting threading dislocation within a semiconductor layer.

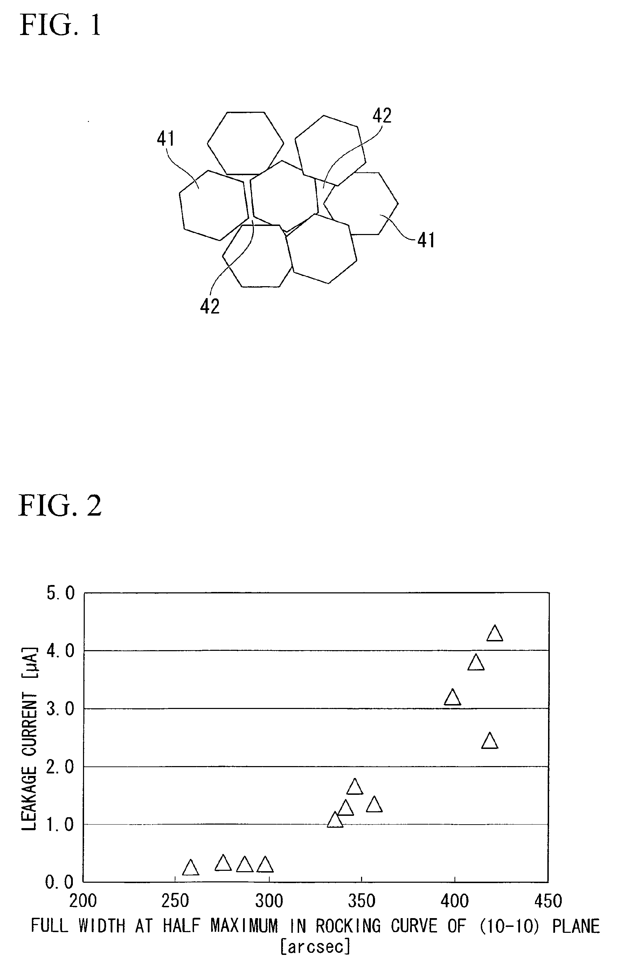

FIG. 1 is a diagram for describing threading dislocation within crystals of a group-III nitride compound semiconductor that constitutes the semiconductor layer of a light-emitting device, and is a schematic illustration viewed from a direction perpendicular to the substrate surface. In FIG. 1, symbol 41 indicates crystals of the group-III nitride compound semiconductor. As shown in FIG. 1, the group-III nitride compound semiconductor crystals 41 have a close-packed crystal structure, in which hexagonal columns have grown vertically on top of the substrate. If the arrangement of the hexagonal columns of the group-III nitride compound semiconductor crystals 41 within the plane of the diagram is such that all of the columns are aligned in the same direction, then no gaps will exist between the columns, but if, as shown in FIG. 1, there is even a slight difference in alignment, voids 42 develop between the hexagonal columns. These voids 42 indicate the degree of orientation of the crystals 41, and are thought to correspond with the level of threading dislocation.

One method of evaluating the degree of orientation of crystals is the rocking curve method, which is measured using X-rays.
FIG. 2 is a graph showing the relationship between the full width at half maximum in rocking curve of a (10-10) plane of a group-III nitride compound semiconductor that constitutes the semiconductor layer of a light-emitting device, and the leakage current of the light-emitting device.
The full width at half maximum detected in the rocking curve method corresponds with the volume of the voids 42 between the hexagonal columnar crystals 41 shown in FIG. 1, and as shown in FIG. 2, the smaller the full width at half maximum detected in the rocking curve method, the smaller the voids and the better the orientation between the hexagonal columnar crystals 41. As a result, when a device is produced, favorable effects such as a smaller leakage current can be achieved.

As a result of intensive investigation of the relationship between the full width at half maximum detected in the rocking curve method and the properties of a light-emitting device, the inventors of the present invention discovered that by ensuring that the full width at half maximum for the semiconductor layer of a light-emitting device is within a predetermined range, a light-emitting device can be provided that has minimal threading dislocation within the semiconductor layer and yields favorable light emission properties, and they were therefore able to complete the present invention.
In other words, the present invention relates to the aspects described below.

[1] A group-III nitride compound semiconductor device comprising a substrate, an intermediate layer provided on the substrate, and a base layer provided on the intermediate layer, in which a full width at half maximum in rocking curve of a (0002) plane is 100 arcsec or lower and a full width at half maximum in rocking curve of a (10-10) plane is 300 arcsec or lower.
[2] The group-III nitride compound semiconductor device according to [1], wherein the full width at half maximum in rocking curve of the (0002) plane is 50 arcsec or lower and the full width at half maximum in rocking curve of the (10-10) plane is 250 arcsec or lower.
[3] The group-III nitride compound semiconductor device according to [1] or [2], wherein the substrate is sapphire.
[4] The group-III nitride compound semiconductor device according to [3], wherein the intermediate layer is formed on a c-plane of the sapphire substrate.
[5] The group-III nitride compound semiconductor device according to any one of [1] to [4], wherein the intermediate layer is formed of AlₓGa₁₋ₓN (0≤x≤1).
[6] The group-III nitride compound semiconductor device according to any one of [1] to [5], wherein the intermediate layer is formed of AlN.
[7] The group-III nitride compound semiconductor device according to any one of [1] to [6], wherein the base layer is formed of AlGaN.
[8] The group-III nitride compound semiconductor device according to any one of [1] to [6], wherein the base layer is formed of GaN.

[9] A group-III nitride compound semiconductor light-emitting device comprising a group-III nitride compound semiconductor device according to any one of [1] to [8], and a semiconductor layer prepared by sequentially laminating an n-type semiconductor layer, a light-emitting layer and a p-type semiconductor layer, wherein the semiconductor layer is formed on the base layer of the group-III nitride compound semiconductor device.
[10] The group-III nitride compound semiconductor light-emitting device according to [9], wherein the n-type semiconductor layer comprises an n-type cladding layer, the p-type semiconductor layer comprises a p-type cladding layer, and the n-type cladding layer and/or the p-type cladding layer comprises at least a superlattice structure.

Furthermore, the inventors of the present invention also focused their attention on the mechanism for the generation of threading dislocations. In particular, because the level of threading dislocation within the base layer can be reduced by using an intermediate layer of excellent uniformity, they investigated methods capable of achieving excellent uniformity for the intermediate layer interposed between the substrate and the base layer. As a result, they discovered that an intermediate layer formed using a sputtering method has superior in-plane uniformity to an intermediate layer formed using a MOCVD method, even when the formed film is very thin, and that by using a sputtering method to form the intermediate layer interposed between the substrate and the base layer, the level of threading dislocation within the base layer could be reduced, and they were therefore able to complete the present invention.

[11] A production method of a group-III nitride compound semiconductor device according to any one of [1] to [8], the method comprising forming the intermediate layer by using a sputtering method.
[12] The production method of a group-III nitride compound semiconductor device according to [11], further comprising forming the base layer by using a MOCVD method.
[13] A production method of a group-III nitride compound semiconductor light-emitting device, the method comprising forming a semiconductor layer by sequentially laminating an n-type semiconductor layer, a light-emitting layer and a p-type semiconductor layer on top of the base layer of a group-III nitride compound semiconductor device according to any one of [1] to [8], and forming the intermediate layer by using a sputtering method. [14] The production method of a group-III nitride compound semiconductor light-emitting device according to [13], further comprising forming the base layer by using a MOCVD method.

[15] A group-III nitride compound semiconductor device produced by the production method according to [11] or [12].
[16] A group-III nitride compound semiconductor light-emitting device produced by the production method according to [13] or [14].
[17] A lamp that uses the group-III nitride compound semiconductor light-emitting device according to any one of [9], [10] and [16].

A group-III nitride compound semiconductor light-emitting device of the present invention has a base layer provided on an intermediate layer provided on a substrate, in which a full width at half maximum in rocking curve of a (0002) plane is 100 arcsec or lower and a full width at half maximum in rocking curve of a (10-10) plane is 300 arcsec or lower, and consequently the level of threading dislocation within the semiconductor layer is minimal, and excellent light emission properties can be obtained.

Further, according to a production method of a group-III nitride compound semiconductor light-emitting device of the present invention, because the intermediate layer is formed using a sputtering method, a uniform intermediate layer can be formed, meaning a base layer in which a full width at half maximum in rocking curve of a (0002) plane is 100 arcsec or lower and a full width at half maximum in rocking curve of a (10-10) plane is 300 arcsec or lower can be formed on the intermediate layer with comparative ease. Accordingly, the production method of a group-III nitride compound semiconductor light-emitting device according to the present invention can readily provide a group-III nitride compound semiconductor light-emitting device of the present invention having minimal threading dislocation within the semiconductor layer and excellent light emission properties.
Furthermore, in the present invention, by adopting a layer constitution in which the n-type cladding layer and/or the p-type cladding layer includes a superlattice structure, a light-emitting device having markedly improved output and superior electrical properties can be obtained.

Moreover, a lamp of the present invention uses a group-III nitride compound semiconductor light-emitting device of the present invention, and therefore has excellent light emission properties.

### BRIEF DESCRIPTION OF THE DRAWINGS

FIG. 1 is a diagram describing threading dislocation within crystals of a group-III nitride compound semiconductor that constitutes the semiconductor layer of a light-emitting device, and is a schematic illustration viewed from a direction perpendicular to the substrate surface.
FIG. 2 is a graph showing the relationship between the full width at half maximum in rocking curve of a (10-10) plane of a group-III nitride compound semiconductor that constitutes the semiconductor layer of a light-emitting device, and the leakage current of the light-emitting device.
FIG. 3 is a schematic cross-sectional view that shows a schematic illustration of one example of a group-III nitride compound semiconductor light-emitting device according to the present invention.
FIG. 4 is a schematic illustration showing the planar structure of the group-III nitride compound semiconductor light-emitting device shown in FIG. 3.
FIG. 5 is a diagram describing a production method of the group-III nitride compound semiconductor light-emitting device shown in FIG. 3, and is a schematic cross-sectional view showing a schematic illustration of the laminated semiconductor.
FIG. 6 is a schematic illustration showing one example of a lamp produced using a group-III nitride compound semiconductor light-emitting device according to the present invention.

### [Description of the reference symbols]

- 1: Group-III nitride compound semiconductor light-emitting device (group-III nitride compound semiconductor device, light-emitting device)
- 3: Lamp
- 10: Laminated semiconductor
- 11: Substrate
- 11a: Surface
- 12: Intermediate layer
- 14: n-type semiconductor layer
- 14c: n-type cladding layer
- 14a: Base layer
- 15: Light-emitting layer
- 16: p-type semiconductor layer
- 16a: p-type cladding layer
- 17: Translucent positive electrode
- 20: Semiconductor layer

### BEST MODE FOR CARRYING OUT THE INVENTION

Embodiments of a group-III nitride compound semiconductor device and a production method thereof, a group-III nitride compound semiconductor light-emitting device and a production method thereof, and a lamp according to the present invention are described below with appropriate reference to the drawings.

### [Group-III Nitride Compound Semiconductor Light-emitting Device]

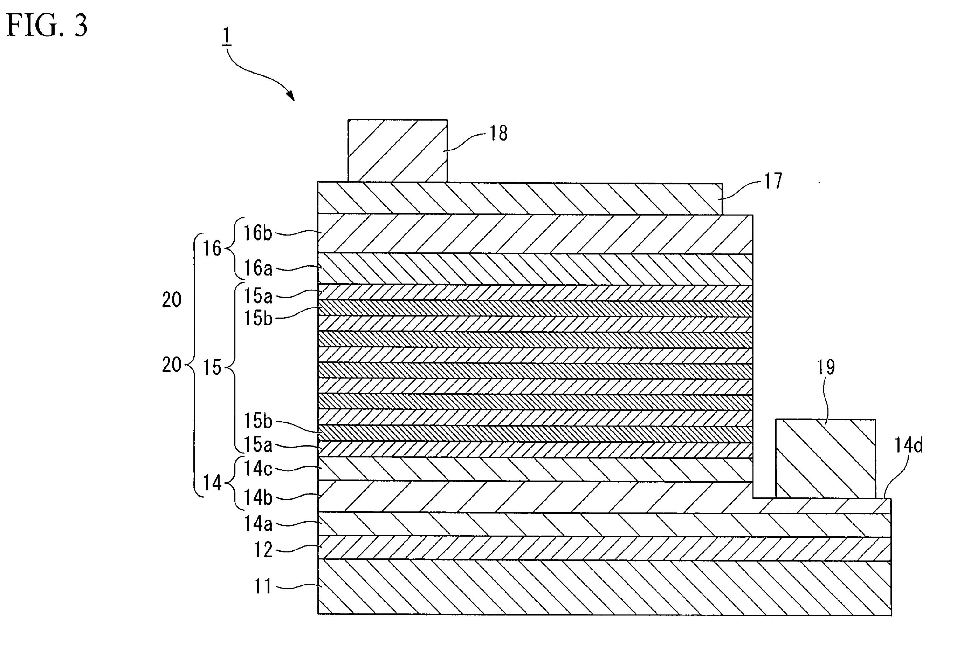

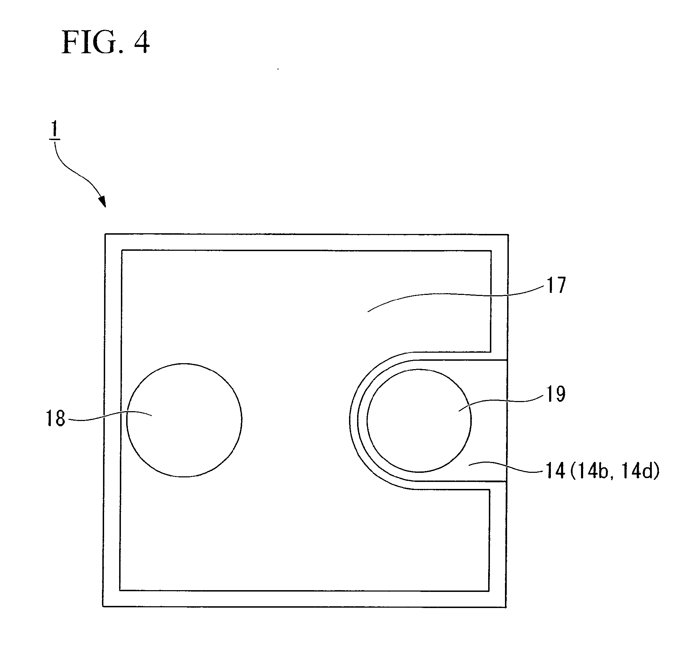

FIG. 3 is a schematic cross-sectional view showing a schematic illustration of one example of a group-III nitride compound semiconductor light-emitting device according to the present invention (a group-III nitride compound semiconductor device: hereafter also abbreviated as a "light-emitting device"). Further, FIG. 4 is a schematic illustration showing the planar structure of the group-III nitride compound semiconductor light-emitting device shown in FIG. 3.
As shown in FIG. 3, the light-emitting device of this embodiment is a one-surface electrode-type device in which an intermediate layer 12, a base layer 14a, and a semiconductor layer 20 formed of a group-III nitride compound semiconductor containing Ga as the group-III element are formed on a substrate 11. As shown in FIG. 3, the semiconductor layer 20 is formed by laminating each of the layers of an n-type semiconductor layer 14, a light-emitting layer 15, and a p-type semiconductor layer 16 in that order.

### [Laminated Structure of Light-emitting Device]

### <Substrate>

In the light-emitting device 1 of the present embodiment, there are no particular limitations on the material used for the substrate 11, provided group-III nitride compound semiconductor crystals are able to undergo epitaxial growth on the surface of the substrate material, and any of a variety of materials may be selected for use. Specific examples of the substrate material include sapphire, SiC, silicon, zinc oxide, magnesium oxide, manganese oxide, zirconium oxide, manganese zinc iron oxide, magnesium aluminum oxide, zirconium boride, gallium oxide, indium oxide, lithium gallium oxide, lithium aluminum oxide, neodymium gallium oxide, lanthanum strontium aluminum tantalum oxide, strontium titanium oxide, titanium oxide, hafnium, tungsten and molybdenum.

Further, of the above substrate materials, the use of sapphire is particularly preferred, and the intermediate layer 12 is preferably formed on the c-plane of the sapphire substrate.

Of the above-mentioned substrate materials, by using an oxide substrate or a metal substrate, which are known to undergo chemical degeneration upon contact with ammonia at high temperature, forming the intermediate layer 12 without using ammonia, and then forming the base layer that constitutes part of the n-type semiconductor layer 14 described below via a method that uses ammonia, the intermediate layer 12, which is described in further detail below, also acts as a coating layer, and is therefore effective in preventing the chemical degeneration of the substrate 11.
Further, the temperature of the substrate 11 can generally be suppressed to a low level in a sputtering method, meaning that even in those cases where a substrate 11 formed of a material that undergoes decomposition at high temperature is used, each of the layers can be formed on the substrate 11 without damaging the substrate.

### <Intermediate Layer>

In the light-emitting device 1 of the present embodiment, an intermediate layer 12 having a hexagonal crystal structure is formed on the substrate 11.
The crystals of the group-III nitride compound semiconductor that constitute the intermediate layer 12 are preferably formed of polycrystalline AlₓGa₁₋ₓN (0≤x≤1), and more preferably of single crystal AlₓGa₁₋ₓN (0≤x≤1).
By controlling the growth conditions, the crystal of the group-III nitride compound semiconductor can be grown not only in the upper direction, but also across the in-plane direction, thereby forming a single crystal structure. Accordingly, by controlling the growth conditions for the intermediate layer 12, an intermediate layer 12 formed of a group-III nitride compound semiconductor crystal having a single crystal structure can be obtained.
When this type of intermediate layer 12 having a single crystal structure is formed on the substrate 11, the buffering function of the intermediate layer 12 is particularly effective, and as a result, the group-III nitride compound semiconductor formed on top of the intermediate layer 12 becomes a crystalline film having excellent orientation and crystallinity.

Further, by controlling the growth conditions, the group-III nitride compound semiconductor crystals that constitute the intermediate layer 12 can be formed as columnar crystals (polycrystals) composed of a texture based on hexagonal columns. Here, the expression "columnar crystals composed of a texture" refers to crystals in which a crystal grain boundary is formed between adjacent crystal grains, and the crystals themselves adopt a columnar shape in a longitudinal cross-section.

The intermediate layer 12 is formed for the purpose of protecting the substrate 11 from chemical reactions at high temperature, for the purpose of moderating any difference in lattice constant between the material of the substrate 11 and the semiconductor layer 20, or for promoting nucleus generation for crystal growth.
As the material for the intermediate layer 12, the use of a group-III nitride compound containing Ga is preferred, and a layer formed of AlₓGa₁₋ₓN (wherein, 0≤x≤1, preferably 0.5≤x≤1, and more preferably 0.9≤x≤1) is particularly desirable. Further, the use of AlN as the material used in forming the intermediate layer 12 is also desirable.

Furthermore, the intermediate layer 12 must be formed so as to cover at least 60% of the surface 11a of the substrate 11, preferably at least 80% of the surface 11a, and more preferably 90% or more of the surface 11a. Furthermore, forming the intermediate layer 12 so as to cover 100% of the surface 11a, namely, so as to cover the entire surface 11a of the substrate 11 without gaps, is the most desirable.
If the region of the surface 11a of the substrate 11 covered by the intermediate layer 12 decreases, then the substrate 11 becomes significantly exposed. In such cases, the lattice constants for the portions of the base layer 14a formed on the intermediate layer 12 and the portions of the base layer 14a formed directly on the substrate 11 tend to differ, meaning uniform crystals cannot be formed, and hillocks and pits are more likely to occur.

Furthermore, in addition to covering the surface 11a of the substrate 11, the intermediate layer 12 may be formed so as to also cover the side surfaces, or formed so as to also cover the back surface of the substrate 11.

### <Base Layer>

The base layer 14a of the n-type semiconductor layer 14 of the present embodiment is formed of a group-III nitride compound semiconductor, and constitutes a group-III nitride compound semiconductor device. The material for the base layer 14a may be either the same as, or different from, the intermediate layer 12, although a group-III nitride compound semiconductor containing Ga, namely a GaN-based compound semiconductor, facilitates dislocation looping and is therefore preferred, and a AlₓGa₁₋ₓN layer (wherein, 0≤x≤1, preferably 0≤x≤0.5, and more preferably 0≤x≤0.1) is particularly desirable. Further, based on testing performed by the inventors of the present invention, as the material used for the base layer 14a, a group-III nitride that contains Ga is preferred, AlGaN is particularly desirable, and GaN is also favorable.

In the present embodiment, although there are no particular limitations on the thickness of the base layer 14a, the thickness is preferably within a range from 0.1 to 20 µm, and more preferably from 0.5 to 15 µm. In order to ensure that the base layer 14a does not simply inherit the crystallinity of the intermediate layer 12 that is the columnar crystalline aggregate with distinct crystal grain boundaries, migration must be used to loop the dislocation, but if the thickness of the base layer 14a is less than 0.5 µm, then the dislocation looping may be unsatisfactory. In contrast, even if the base layer 14a is formed with a thickness exceeding 20 µm, there is no change in the function of the layer, and the production time is simply extended unnecessarily.

If necessary, the base layer 14a may be doped with an n-type impurity, provided the doping quantity is within a range from 1 × 10¹⁷ to 1 × 10¹⁹ /cm³, but an undoped layer (< 1 × 10¹⁷ /cm³) may also be formed, and an undoped layer is preferred in terms of maintaining favorable crystallinity.
For example, in those cases where the substrate 11 has conductivity, by doping the base layer 14a with a dopant to make the layer conductive, electrodes can be formed on the top and bottom of the light-emitting device 1. In contrast, in those cases where an insulating material is used as the substrate 11, because a chip structure must be adopted in which both the positive electrode and the negative electrode are provided on the same surface of the light-emitting device 1, forming the layer provided directly on the substrate 11 from an undoped crystal yields superior crystallinity and is consequently preferred. There are no particular limitations on the n-type impurity, and suitable examples include Si, Ge and Sn, and of these, Si and Ge are preferred.

For the base layer 14a, the full width at half maximum in rocking curve of the (0002) plane is 100 arcsec or lower, and the full width at half maximum in rocking curve of the (10-10) plane is 300 arcsec or lower. Furthermore, for the base layer 14a, the full width at half maximum in rocking curve of the (0002) plane is preferably 50 arcsec or lower, and the full width at half maximum in rocking curve of the (10-10) plane is preferably 250 arcsec or lower.
In the present invention, the expression "full width at half maximum in rocking curve" refers to the full width at half maximum in an X-ray diffraction rocking curve. Furthermore, in the present invention, measurement of the "full width at half maximum in rocking curve" was conducted using an X-ray generator for which the output voltage was 45 kV and the electrical current was 40 mA, in which a double diffraction Ge hybrid monochromator was provided as the monochromator in the incident optical system, and the divergent beam from the X-ray tube was converted to a monochromatic parallel beam. On the other hand, as the receiving optical system, a triple axis module with a resolution of 12" was used, and a proportional counter was used as the X-ray detector. Further, a 1/8" slit was used as the divergence slit on the X-ray generator side, and the X-ray beam diameter was focused down to dimensions of height: 10 mm × width: 0.365 mm.

A laminated semiconductor structure can be provided on top of the base layer 14a formed of the group-III nitride compound semiconductor. For example, in those cases where a laminated semiconductor structure is formed as a light-emitting device, a laminated structure can be formed by laminating n-type conductive layers doped with an n-type dopant such as Si, Ge or Sn, and p-type conductive layers doped with a p-type dopant such as magnesium. Further, in terms of materials, InGaN can be used for the light-emitting layer or the like, and AlGaN can be used for the cladding layer or the like. In this manner, by forming a group-III nitride compound semiconductor crystal layer having a specific function on top of the base layer 14a, a wafer can be produced that has the type of laminated semiconductor structure used in preparing a light-emitting diode, a laser diode, or an electronic device or the like.

### <Semiconductor Layer>

As shown in FIG. 3, the semiconductor layer 20 includes an n-type semiconductor layer 14, a light-emitting layer 15, and a p-type semiconductor layer 16.

### [n-type Semiconductor Layer]

The n-type semiconductor layer 14 is laminated on top of the base layer 14a, and is composed of an n-type contact layer 14b and an n-type cladding layer 14c.
The n-type contact layer can also function as a base layer and/or an n-type cladding layer, whereas the base layer can also function as an n-type contact layer and/or an n-type cladding layer.

### (n-type Contact Layer)

The n-type contact layer 14b is formed of a group-III nitride compound semiconductor. In the same manner as the base layer 14a, the n-type contact layer 14b is preferably formed of a AlₓGa₁₋ₓN layer (wherein, 0≤x≤1, preferably 0≤x≤0.5, and more preferably 0≤x≤0.1).
Further, the n-type contact layer 14b is preferably doped with an n-type impurity, and incorporating the n-type impurity at a concentration of 1 × 10¹⁷ to 1 × 10¹⁹ /cm³, and preferably 1 × 10¹⁸ to 1 × 10¹⁹ /cm³ is preferred in terms of maintaining a favorable ohmic contact with the negative electrode, suppressing the occurrence of cracking, and maintaining a favorable level of crystallinity. There are no particular limitations on the n-type impurity, and suitable examples include Si, Ge and Sn, and of these, Si and Ge are preferred.

The gallium nitride-based compound semiconductors that constitute the base layer 14a and the n-type contact layer 14b are preferably of the same composition, and the combined thickness of these layers is typically set within a range from 0.1 to 20 µm, preferably from 0.5 to 15 µm, and more preferably from 1 to 12 µm. Provided the thickness is within this range, the crystallinity of the semiconductor can be favorably maintained.

### (n-type Cladding Layer)

An n-type cladding layer 14c is preferably disposed between the n-type contact layer 14b and the light-emitting layer 15. By providing the n-type cladding layer 14c, a number of effects such as the supply of electrons to the active layer (the light-emitting layer 15) and moderation of the difference in lattice constants can be obtained. The n-type cladding layer 14c can be formed using AlGaN, GaN or GaInN or the like. Further, the n-type cladding layer 14c may be either a heterojunction of these structures or a superlattice structure formed by laminating a plurality of layers. When the n-type cladding layer 14c is formed of GaInN, needless to say, it is preferable that the band gap is larger than the band gap of the GaInN of the light-emitting layer 15.

The n-type dopant concentration within the n-type cladding layer 14c is preferably within a range from 1 × 10¹⁷ to 1 × 10²⁰ /cm³, and more preferably from 1 × 10¹⁸ to 1 × 10¹⁹ /cm³. A dopant concentration within this range is preferred in terms of maintaining favorable crystallinity and reducing the operating voltage of the light-emitting device.

In those cases where the n-type cladding layer 14c incorporates a superlattice structure, although not shown in detail in the drawings, the layer may include a laminated structure composed of an n-side first layer formed of a group-III nitride compound semiconductor having a film thickness of not more than 100 angstroms, and an n-side second layer having a different composition from the n-side first layer and formed of a group-III nitride compound semiconductor having a film thickness of not more than 100 angstroms. Further, the n-type cladding layer 14c may also include a structure in which the n-side first layer and the n-side second layer are laminated repeatedly in an alternating arrangement. Furthermore, a structure in which either the n-side first layer or the n-side second layer contacts the active layer (the light-emitting layer 15) is preferred.

The above-mentioned n-side first layer and n-side second layer can be formed, for example, using an AlGaN system containing Al (hereafter also referred to as simply "AlGaN"), a GaInN system containing In (hereafter also referred to as simply "GaInN"), or GaN. Further, the n-side first layer and the n-side second layer may also be a GaInN/GaN alternating structure, an AlGaN/GaN alternating structure, a GaInN/AlGaN alternating structure, a GaInN/GaInN alternating structure having a different composition for each layer (in the present invention, the expression "different composition" refers to a different compositional ratio for each of the component elements, this definition also applies below), or an AlGaN/AlGaN alternating structure having a different composition for each layer. In the present invention, the n-side first layer and the n-side second layer preferably have either a GaInN/GaN alternating structure, or a GaInN/GaInN alternating structure having a different composition for each layer.

The superlattice layers of the n-side first layer and the n-side second layer are preferably not more than 60 angstroms in each case, are more preferably 40 angstroms or less, and are most preferably within a range from 10 to 40 angstroms. If the film thickness of the n-side first layer and n-side second layer that form the superlattice layer exceed 100 angstroms, then crystal defects become more prevalent.

The n-side first layer and the n-side second layer may be doped structures, or may be a combination of a doped structure and an undoped structure. As the doping impurity, any of the conventional impurities used for doping the above material compositions can be used without any particular limitations. For example, in those cases where a GaInN/GaN alternating structure or a GaInN/GaInN alternating structure having a different composition for each layer is used as the n-type cladding layer, Si is preferred as the impurity. Further, the above-mentioned n-type superlattice multilayer film may be prepared with doping switched appropriately ON and OFF, even if the composition such as GaInN, AlGaN or GaN is the same.

### <Light-emitting Layer>

The light-emitting layer 15 is the layer that is laminated onto the n-type semiconductor layer 14, and onto which is then laminated the p-type semiconductor layer 16. The light-emitting layer 15 may adopt a multiple quantum well structure, a single quantum well structure, or a bulk structure or the like. In the present embodiment, the light-emitting layer 15 has, as shown in FIG. 3, a structure in which barrier layers 15a formed of a gallium nitride-based compound semiconductor and well layers 15b formed of a gallium nitride-based compound semiconductor that contains indium are laminated alternately and repeatedly, such that a barrier layer 15a is positioned adjacent to both the n-type semiconductor layer 14 and the p-type semiconductor layer 16. In the example shown in FIG. 3, the light-emitting layer 15 has a multiple quantum well structure in which six barrier layers 15a and five well layers 15b are laminated alternately and repeatedly, such that a barrier layer 15a is formed as both the uppermost layer and the lowermost layer of the light-emitting layer 15, while a well layer 15b is positioned between each pair of barrier layers 15a.

As the barrier layer 15a, for example, a gallium nitride-based compound semiconductor such as Al_{c}Ga_{1-c}N (0≤c<0.3) having a larger band gap energy than the well layer 15b can be used favorably.
Further, as the well layer 15b, for example, a gallium indium nitride such as Ga₁₋ₛInₛN (0<s<0.4) can be used as a gallium nitride-based compound semiconductor that contains indium.

### <p-type Semiconductor Layer>

The p-type semiconductor layer 16 is composed of a p-type cladding layer 16a and a p-type contact layer 16b. The p-type contact layer may also function as a p-type cladding layer.

### (p-type Cladding Layer)

Although there are no particular limitations on the p-type cladding layer 16a, provided it has a composition that exhibits a larger band gap energy than that of the light-emitting layer 15 and is capable of confining a carrier in the light-emitting layer 15, examples of preferred layers include those formed of Al_{d}Ga_{1-d}N (wherein 0<d≤0.4, and preferably 0.1≤d≤0.3). A p-type cladding layer 16a composed of this type of AlGaN is preferred in terms of confining a carrier in the light-emitting layer 15.

The p-type dopant concentration within the p-type cladding layer 16a is preferably within a range from 1 × 10¹⁸ to 1 × 10²¹ /cm³, and more preferably from 1 × 10¹⁹ to 1 × 10²⁰ /cm³. A p-type dopant concentration within this range enables a favorable p-type crystal to be obtained with no deterioration in the crystallinity. Although there are no particular limitations on the p-type impurity, Mg is preferred. The p-type cladding layer 16a may also be formed as a superlattice structure having a plurality of laminated layers.

In those cases where the p-type cladding layer 16a incorporates a superlattice structure, although not shown in detail in the drawings, the layer may include a laminated structure composed of a p-side first layer formed of a group-III nitride compound semiconductor having a film thickness of not more than 100 angstroms, and a p-side second layer having a different composition from the p-side first layer and formed of a group-III nitride compound semiconductor having a film thickness of not more than 100 angstroms. Further, the p-type cladding layer 16a may also include a structure in which the p-side first layer and the p-side second layer are laminated repeatedly in an alternating arrangement.

The above-mentioned p-side first layer and p-side second layer can be formed, for example, from any one of AlGaN, GaInN and GaN, with a different composition for each layer. Further, the p-side first layer and p-side second layer may also be formed as a GaInN/GaN alternating structure, an AlGaN/GaN alternating structure, or a GaInN/AlGaN alternating structure. In the present invention, the p-side first layer and the p-side second layer preferably have either a AlGaN/AlGaN structure, or an AlGaN/GaN alternating structure.

The superlattice layers of the p-side first layer and the p-side second layer are preferably not more than 60 angstroms in each case, are more preferably 40 angstroms or less, and are most preferably within a range from 10 to 40 angstroms. If the film thickness of the p-side first layer and p-side second layer that form the superlattice layer exceed 100 angstroms, then the layer tends to contain many crystal defects, which is undesirable.

The p-side first layer an the p-side second layer may be doped structures, or may be a combination of a doped structure and an undoped structure. As the doping impurity, any of the conventional impurities used for doping the above material compositions can be used without any particular limitations. For example, in those cases where an AlGaN/GaN alternating structure or an AlGaN/AlGaN alternating structure having a different composition for each layer is used as the p-type cladding layer, Mg is preferred as the impurity. Further, the above-mentioned p-type superlattice multilayer film may be prepared with doping switched appropriately ON and OFF, even if the composition such as GaInN, AlGaN or GaN is the same.

### (p-type Contact Layer)

The p-type contact layer 16b is a gallium nitride-based compound semiconductor layer that contains at least AlₑGa₁₋ₑN (wherein 0≤e<0.5, preferably 0≤e≤0.2, and more preferably 0≤e≤0.1). An Al composition within the above range is preferred in terms of maintaining a favorable level of crystallinity, and achieving a favorable ohmic contact with a p-ohmic electrode (refer to a translucent electrode 17 described below).

Further, incorporating a p-type dopant at a concentration of 1 × 10¹⁸ to 1 × 10²¹ /cm³ within the p-type contact layer 16b is preferred in terms of maintaining a favorable ohmic contact, preventing the occurrence of cracking, and maintaining a favorable level of crystallinity. The p-dopant concentration is more preferably within a range from 5 × 10¹⁹ to 5 × 10²⁰ /cm³. There are no particular limitations on the p-type impurity, although Mg is preferred.

The semiconductor layer 20 that constitutes the light-emitting device 1 is not restricted to the embodiment described above.
For example, as the material used for forming the semiconductor layer of the present invention, typically known materials besides those described above include gallium nitride-based compound semiconductors represented by Al_{X}Ga_{Y}In_{Z}N_{1-A}M_{A} (wherein, 0≤X≤1, 0≤Y≤1 and 0≤Z≤1, provided that X+Y+Z = 1, the symbol M represents a group-V element other than nitrogen (N), and 0≤A<1), and these known gallium nitride-based compound semiconductors may be used in the present invention without any particular limitations.
Further, the group-III nitride compound semiconductor containing Ga as the group-III element may also contain another group-III element other than Al, Ga and In, and if necessary, may also include an element such as Ge, Si, Mg, Ca, Zn, Be, P, As or B. Moreover, the semiconductor may include not only elements that have been intentionally added, but also impurities that are unavoidably incorporated as a result of the film formation conditions employed, and very small quantities of impurities included in raw materials or reaction tube materials.

### <Translucent Positive Electrode>

The translucent positive electrode 17 is an electrode having translucency that is formed on top of the p-type semiconductor layer 16.
There are no particular limitations on the material used for the translucent positive electrode 17, and materials such as ITO (In₂O₃ - SnO₂), AZO (ZnO - Al₂O₃), IZO (In₂O₃ - ZnO), and GZO (ZnO - Ga₂O₃) can be used. As the translucent positive electrode 17, any structure may be used without any particular limitations, including any of the conventionally known structures.
Further, the translucent positive electrode 17 may be formed so as to cover the entire surface of the p-type semiconductor layer 16, or may be formed in a lattice shape or branched shape with gaps therein.

### <Positive Electrode Bonding Pad>

A positive electrode bonding pad 18 is a substantially circular electrode formed on the transparent positive electrode 17, as shown in FIG. 4.
As the material for the positive electrode bonding pad 18, various structures using Au, Al, Ni and Cu are well known, and any of these known materials or structures may be used without any limitations.
The thickness of the positive electrode bonding pad 18 is preferably within a range from 100 to 1,000 nm. Further, in terms of the bonding pad properties, a larger thickness yields superior bondability, and therefore the thickness of the positive electrode bonding pad 18 is more preferably not less than 300 nm. Moreover, from the viewpoint of production costs, the thickness is preferably not more than 500 nm.

### <Negative Electrode>

A negative electrode 19 contacts the n-type contact layer 14b of the n-type semiconductor layer 14 that constitutes part of the semiconductor layer 20. Accordingly, as shown in FIG. 3 and FIG. 4, the negative electrode 19 is formed in a substantially circular shape on the exposed region 14d that is formed by removing a portion of the p-type semiconductor layer 16, the light-emitting layer 15 and the n-type semiconductor layer 14 to expose the n-type contact layer 14b. As the material for the negative electrode 19, negative electrodes of various compositions and structures are already well known, and any of these known negative electrodes can be used without any particular limitations.

### [Production Method of Light-emitting Device]

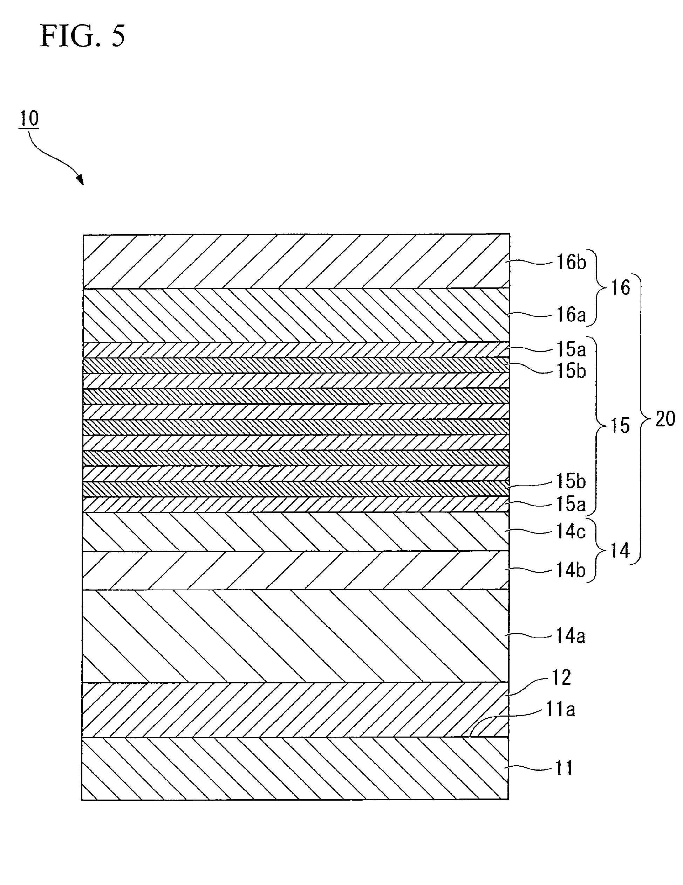

In order to produce the light-emitting device 1 shown in FIG. 3, a laminated semiconductor 10 shown in FIG. 5 is first formed, by forming the semiconductor layer 20 on top of the substrate 11. In order to form the laminated semiconductor 10 shown in FIG. 5, the substrate 11 is first prepared. This substrate 11 is preferably subjected to a pretreatment prior to use.
For example, if a substrate 11 formed of silicon is used, a pretreatment method can be used in which the surface is subjected to hydrogen termination by conducting a wet treatment such as the well-known RCA cleaning method. This pretreatment stabilizes the film formation process.

Further, the substrate 11 may also be placed inside the chamber of a sputtering apparatus, and pretreated using a sputtering method or the like prior to formation of the intermediate layer 12. Specifically, a pretreatment for cleaning the surface of the substrate can be conducted by exposing the substrate 11 to an Ar or N₂ plasma inside the chamber. By treating the surface of the substrate 11 with a plasma of Ar gas or N₂ gas or the like, any organic material or oxides adhered to the surface of the substrate 11 can be removed. In such a case, if no power is applied to the target, but rather, a voltage is applied between the substrate 11 and the chamber, then the plasma particles will act efficiently on the substrate 11.

Following pretreatment of the substrate 11, a sputtering method is used to form the intermediate layer 12 shown in FIG. 5 on the substrate 11.
As the film formation method for the intermediate layer 12, any of the methods generally known as crystal growth methods for group-III nitride compound semiconductors can be used without any particular problems, and methods that may be used include MOCVD methods, MBE methods (Molecular Beam Epitaxy methods), sputtering methods, and HVPE methods (Hydride Vapor Phase Epitaxy methods).
The orientation of the n-type semiconductor layer 14 formed on the intermediate layer 12 is affected significantly by the state of the intermediate layer 12. Until now, MOCVD methods have been preferred in order to achieve an intermediate layer 12 of high crystallinity. However, the MOCVD method is a method in which a metal generated by decomposition of a raw material on the surface of the substrate 11 is gradually accumulated on the substrate. However, in the MOCVD method, because nuclei are first formed, and crystals are then grown around the periphery of these nuclei to gradually form the film, in those cases where a very thin film such as the intermediate layer 12 is formed, the film uniformity may sometimes be unsatisfactory. In contrast, a sputtering method enables a uniform film to be formed even when forming a very thin film, and is also very applicable to mass production, and is consequently preferred. An intermediate layer 12 having a single crystal structure, or an intermediate layer 12 having a columnar crystal structure (a polycrystal) of a suitable structure can be formed with comparative ease.

If the intermediate layer 12 is to be formed using a sputtering method, then because a DC sputtering method tends to invite charge-up of the target surface and is prone to instability in the film formation rate, a pulsed DC sputtering method or RF (high-frequency) sputtering method is preferred. Further, amongst sputtering methods, methods in which the efficiency is improved by confining the plasma within a magnetic field are in general use, and in order to achieve a uniform film thickness, the position of the magnet is preferably moved within the target. The specific method of moving the magnet may be selected in accordance with the apparatus being used, and may be either swung or rotated. By employing this type of operation, an intermediate layer 12 having a single crystal structure or an intermediate layer 12 having an appropriate density of columnar crystals with distinct crystal grain boundaries can be formed.

When the intermediate layer 12 is formed using a sputtering method, the substrate temperature during film formation is preferably from 300 to 800°C. At a temperature less than this range, the entire surface of the substrate 11 may not be able to be covered by the intermediate layer 12, and portions of the surface of the substrate 11 may remain exposed. In contrast, at a temperature exceeding the above range, migration of the metal raw material becomes very active, and it becomes difficult to form an intermediate layer 12 having columnar crystals with distinct crystal grain boundaries, which is also undesirable. Further, at a temperature exceeding the above range, the growth rate for the crystal becomes extremely slow, and it becomes difficult to form an intermediate layer 12 having a single crystal structure, which is also undesirable.

Furthermore, when the intermediate layer 12 is formed using a sputtering method, the pressure inside the chamber is preferably at least 0.3 Pa. At a pressure less than this range, the quantity of nitrogen present decreases, and the sputtered metal may adhere to the substrate without becoming a nitride. Furthermore, although there are no particular limitations on the upper limit for the pressure inside the chamber, needless to say, the pressure must be sufficiently low to enable generation of the plasma.

Further, there is also a preferred range for the ratio of the nitrogen flow rate relative to the flow rate of the nitrogen raw material and the inert gas within the chamber. If this nitrogen flow rate ratio is too low, then there is a possibility that the sputtered metal may adhere as an unmodified metal, whereas if the nitrogen flow rate ratio is too high, then the quantity of inert gas tends to be too small, and the sputtering rate tends to fall.
When forming an intermediate layer 12 having a single crystal structure, the ratio of the nitrogen flow rate relative to the flow rate of the nitrogen raw material and the inert gas within the chamber is preferably such that the nitrogen raw material represents at least 50% but no more than 100%, preferably at least 60% but no more than 90%, more preferably at least 70% but no more than 80%, and most preferably 75%.
Furthermore, when forming an intermediate layer 12 having columnar crystals (a polycrystal), the ratio of the nitrogen flow rate relative to the flow rate of the nitrogen raw material and the inert gas within the chamber is preferably such that the nitrogen raw material represents at least 1% but no more than 50%, preferably at least 10% but no more than 40%, more preferably at least 20% but no more than 30%, and most preferably 25%.
As the nitrogen raw material used in this technique, any of the typically known compounds may be used without any particular problems. In those cases where nitrogen gas is used as the nitrogen raw material, a simple apparatus suffices, but a high reaction rate cannot be obtained. However, by decomposing the nitrogen using an electric field or heat or the like prior to its introduction into the apparatus, a usable film formation rate can be achieved, although the rate is still inferior to that obtained using ammonia.
Accordingly, if due consideration is also given to the cost of the apparatus, nitrogen is the most favorable nitrogen raw material.

In those cases where the intermediate layer 12 is formed using a sputtering method, by setting the substrate temperature during film formation, the pressure inside the chamber, and the ratio of the nitrogen flow rate relative to the flow rate of the nitrogen and the inert gas within the chamber to values within the respective ranges described above, an intermediate layer 12 having a single crystal structure or an intermediate layer 12 having a favorable density of columnar crystals with distinct crystal grain boundaries can be formed.
By forming the intermediate layer 12 using a sputtering method in this manner, an intermediate layer 12 with favorable in-plane uniformity formed of either a single crystal structure or a columnar crystal layer in which the crystal surfaces are aligned can be formed, and an n-type semiconductor layer 14 with excellent crystal orientation can be formed by epitaxial growth on this intermediate layer 12 with favorable in-plane uniformity.
For example, by using a MOCVD method to form a GaN-based compound semiconductor on top of the intermediate layer 12, the single crystal structure or columnar crystal layer having aligned crystal surfaces acts as a growth nucleus, enabling crystal growth with very low dislocation density.

Subsequently, as shown in FIG. 5, the base layer 14a is formed on the substrate 11 having the intermediate layer 12 formed thereon.
Following formation of the intermediate layer 12, annealing need not necessarily be conducted prior to formation of the base layer 14a. In those cases where the base layer 14a is formed using a vapor phase chemical deposition method such as a MOCVD method, MBE method or HVPE method, the substrate is generally subjected to a temperature raising step and a temperature stabilizing step that are conducted without accompanying the film formation. During these steps, a group-V raw material gas is often passed through the system, and as a result, an annealing effect may be generated. However, this process does not represent a special application of an annealing effect, but is merely a typical conventional technique.

Further, the carrier gas passed through the system can use any typical gas without any particular problems. In other words, hydrogen or nitrogen, which are widely used in vapor phase chemical deposition methods such as MOCVD, may be used.
However, raising the temperature in the presence of hydrogen, which is chemically comparatively active, may cause a deterioration in the crystallinity or the smoothness of the crystal surface, and should therefore not be conducted over a long period.

There are no particular limitations on the technique used for laminating the base layer 14a, provided it is a crystal growth technique that is capable of looping dislocation in the manner described above. MOCVD methods, MBE methods and HVPE methods are preferred as they enable dislocation looping to be achieved by migration, meaning a film of favorable crystallinity can be formed. Of these methods, the MOCVD method yields a film with the best level of crystallinity, and is therefore preferred.

When film formation of the base layer 14a is conducted using a MOCVD method, the substrate temperature is preferably at least 800°C. A high substrate temperature facilitates atom migration, thereby facilitating dislocation looping. The substrate temperature is more preferably 900°C or higher, and still more preferably 1,000°C or higher. Needless to say, the substrate temperature during film formation of the base layer 14a must be lower than the temperature at which the crystals decompose, and temperatures of 1,200°C or higher are unsuitable as growing temperatures for the base layer 14a.

Further, the base layer 14a may also be formed using a sputtering method. In those cases where the base layer 14a is formed using a sputtering method, the film formation apparatus is considerably simpler than that required for a MOCVD method or MBE method, which is desirable.

If film formation of the base layer 14a is conducted using a sputtering method, then for example, argon or nitrogen gas is first introduced into the chamber of the sputtering apparatus, the temperature of the substrate 11 is then increased, a high-frequency bias is applied to the substrate 11 while power is applied to the sputtering target formed of metallic Ga, and the base layer 14a is then deposited on the substrate 11 while the pressure inside the chamber is maintained at a predetermined pressure.

In terms of the sputtering method, a RF (high-frequency) sputtering method or DC sputtering method is preferably used to apply the power to the sputtering target.

Furthermore, in those cases where the base layer 14a is formed using a sputtering method, conducting the film formation via a reactive sputtering method in which the nitride raw material is passed through the reactor is particularly preferred in terms of maintaining a favorable level of crystallinity by controlling the reaction, and stably reproducing that favorable level of crystallinity.
When a reactive sputtering method is used, a RF sputtering method is preferred as it enables more ease control of the film formation rate. In a DC sputtering method, if reactive sputtering is used, then the sputtering target tends to charge-up if the electric field is applied continuously by DC, making it difficult to achieve a high film formation rate, and therefore a pulsed DC sputtering method in which the bias is applied in a pulsed manner is preferred.
Further, when a semiconductor layer is formed using a sputtering method, the magnetic field is preferably either rotated or swung relative to the sputtering target. Particularly in the case of RF sputtering, conducting film formation while the position of the magnet is moved within the sputtering target is a method that yields a particularly uniform film thickness.

In the present embodiment, the ratio of the N₂ flow rate relative to the combined flow rate of nitrogen (N₂) and argon (Ar) is preferably within a range from at least 20% to not more than 90%. If the N₂ flow rate ratio is less than this range, then the sputtered metal tends to adhere to the substrate as unmodified metal. In contrast, if the N₂ flow rate ratio exceeds the above range, then the quantity of Ar becomes overly small, and the sputtering rate tends to fall.
Furthermore, in the present embodiment, the N₂ concentration within the gas inside the chamber of the sputtering apparatus is increased, and the heavier gas Ar is then mixed at the flow rate ratio described above. If the gas within the chamber is solely N₂, then the impact strength on the metal target is weak, and there is a limit to the film formation rate that can be achieved. In this embodiment, by mixing the heavier Ar at the flow rate ratio described above, the film formation rate can be increased, and the level of migration on the substrate 11 can be activated.

As the nitrogen raw material used in the present embodiment, besides the N₂ gas described above, any generally known nitrogen compound can be used without any limitations, although ammonia and N₂ gas are preferred, as they are easy to handle and can be obtained comparatively cheaply. If a method is used in which the nitrogen gas is decomposed using an electric field or heat or the like prior to introduction into the apparatus, then a film formation rate can be achieved which, although being lower than that obtained using ammonia, is still sufficient for use in industrial production, and therefore if due consideration is also given to the cost of the apparatus, N₂ gas is the most favorable nitrogen source.

In the production method according to this embodiment, during formation of the base layer 14a, the pressure inside the chamber is preferably not more than 10 Pa, more preferably not more than 5 Pa, and is most preferably 1 Pa or less. Provided the pressure inside the chamber satisfies this range, a base layer 14a with favorable crystallinity can be formed with a high degree of efficiency. If the pressure inside the chamber exceeds 10 Pa, then there is a possibility that a base layer 14a of favorable crystallinity may become unobtainable.
Further, the pressure inside the chamber during formation of the base layer 14a using a sputtering method is preferably not less than 0.3 Pa. If the pressure inside the chamber is less than 0.3 Pa, then the quantity of nitrogen present becomes overly small, and the sputtered metal may adhere to the substrate 11 without becoming a nitride.

The temperature of the substrate 11 during formation of the base layer 14a by sputtering is preferably within a range from 400 to 1,300°C. Increasing the temperature of the substrate 11 during the film formation of the base layer 14a facilitates atom migration, thereby facilitating dislocation looping. Further, the temperature of the substrate 11 during formation of the base layer 14a must be lower than the temperature at which the crystals decompose, and is preferably less than 1,300°C.
In the production method of the present embodiment, by setting the temperature of the substrate 11 to a temperature within the above-mentioned range during film formation of the base layer 14a using a sputtering method, the movement at the crystal surface of the reaction seeds (the metal extracted from the metal target) reaching the substrate 11 can be activated, enabling the formation of a base layer 14a of excellent crystallinity.

Furthermore, the film formation rate during formation of the base layer 14a by a sputtering method is preferably within a range from 0.1 to 10 nm/second. If this film formation rate is less than 0.1 nm/s, then the film formation process takes a very long time, which is wasteful from an industrial production perspective. In contrast, if the film formation rate exceeds 10 nm/s, then obtaining a favorable film becomes problematic.

By forming the base layer 14a using a sputtering method, the film formation rate can be increased beyond that obtainable using a MOCVD method, which enables a shortening of the film formation (production) time. Further, by shortening the production time, contamination of the inside of the chamber of the sputtering apparatus with impurities can be suppressed to a minimal level, meaning a high-quality base layer 14a can be formed.

Subsequently, as shown in FIG. 5, the n-type contact layer 14b, the n-type cladding layer 14c, the light-emitting layer 15 composed of the barrier layers 15a and well layers 15b, and the p-type cladding layer 16a and p-type contact layer 16b of the p-type semiconductor layer 16 can be formed on the substrate 11 having the base layer 14a formed thereon, using a MOCVD method (metal-organic chemical vapor deposition method) that enables the formation of layers of superior crystallinity.

In the MOCVD method, hydrogen (H₂) or nitrogen (N₂) can be used as the carrier gas, trimethyl gallium (TMG) or triethyl gallium (TEG) can be used as the Ga source that represents the group-III raw material, trimethyl aluminum (TMA) or triethyl aluminum (TEA) can be used as the Al source, trimethyl indium (TMI) or triethyl indium (TEI) can be used as the In source, and ammonia or hydrazine can be used as the N source that represents the group-V raw material.

In terms of dopant element n-type impurities, monosilane (SiH₄) or disilane (Si₂H₆) can be used as the Si raw material, and germane gas (GeH₄) or an organogermanium compound such as tetramethyl germanium ((CH₃)₄Ge) or tetraethyl germanium ((C₂H₅)₄Ge) can be used as the Ge raw material.
In terms of dopant element p-type impurities, biscyclopentadienyl magnesium (Cp₂Mg) or bisethylcyclopentadienyl magnesium (EtCp₂Mg) can be used as the Mg raw material.

Using a photolithography method, the translucent positive electrode 17 and the positive electrode bonding pad 18 can then be formed sequentially on the p-type contact layer 16b of the laminated semiconductor 10 shown in FIG. 5 obtained in the manner described above.
Subsequently, the laminated semiconductor 10 with the translucent positive electrode 17 and the positive electrode bonding pad 18 formed thereon is subjected to dry etching to expose an exposed region 14d on the n-type contact layer 14b.
A photolithography method is then used to form the negative electrode 19 on the exposed region 14d, thus yielding the light-emitting device 1 shown in FIG. 3 and FIG. 4.

The light-emitting device 1 of the present embodiment is provided with a base layer 14a that is provided on top of the intermediate layer 12 formed on the substrate 11, and the base layer 14a has a full width at half maximum in rocking curve of a (0002) plane that is 100 arcsec or lower and a full width at half maximum in rocking curve of a (10-10) plane that is 300 arcsec or lower, and as a result, the level of threading dislocation within the base layer 14a is minimal, and excellent light emission properties can be achieved.

Furthermore, in the production method for the light-emitting device 1 according to this embodiment, because the intermediate layer 12 is formed using a sputtering method, a uniform intermediate layer 12 can be formed even when the layer is thin, meaning a base layer 14a having a full width at half maximum in rocking curve of a (0002) plane of 100 arcsec or lower and a full width at half maximum in rocking curve of a (10-10) plane of 300 arcsec or lower can be formed on the intermediate layer 12 with comparative ease. Accordingly, the production method of a light-emitting device 1 according to the present invention can readily provide a light-emitting device 1 that has minimal threading dislocation within the semiconductor layer 20 and excellent light emission properties.
Furthermore, in the light-emitting device 1 of the present embodiment, because the n-type contact layer 14b and n-type cladding layer 14c of the n-type semiconductor layer 14, the light-emitting layer 15, and the p-type semiconductor layer 16 are formed sequentially on top of the base layer 14a having minimal threading dislocation, the level of threading dislocation within the light-emitting layer 15 and the p-type semiconductor layer 16 is also minimal, meaning the light-emitting device 1 has minimal threading dislocation within the semiconductor layer 20 and exhibits excellent light emission properties.

The production method of a light-emitting device 1 according to the present invention is not restricted to the embodiment described above, and film formation of the semiconductor layer 20 may be conducted using a combination of any of the methods capable of growing a semiconductor layer, such as sputtering methods, MOCVD methods (metal-organic chemical vapor deposition methods), HVPE methods (hydride vapor phase epitaxy methods) and MBE methods (molecular beam epitaxy methods).

Furthermore, besides the light-emitting device described above, the group-III nitride compound semiconductor device of the present invention can also be used in photoelectric conversion devices such as laser devices and light-receiving devices, and also in electronic devices such as HBT and HEMT. A multitude of these semiconductor devices with all manner of structures are already known, and the structure of the group-III nitride compound semiconductor device according to the present invention is not limited in any particular manner, and includes all of these conventional device structures.

### [Lamp]

A lamp of the present invention uses a light-emitting device according to the present invention.
Examples of the lamp of the present invention include lamps formed using a combination of a light-emitting device of the present invention and a phosphor. A lamp containing a combination of a light-emitting device and a phosphor can be formed with a conventional configuration known to those skilled in the art, and can be produced using techniques known to those skilled in the art. Further, techniques for changing the light emission color by combining a light-emitting device and a phosphor are also well known, and these types of techniques may be adopted within a lamp of the present invention without any particular restrictions.

For example, by appropriate selection of the phosphor used in the lamp, light emission having a longer wavelength than that of the light-emitting device can be achieved. Furthermore, by mixing the emission wavelength of the light-emitting device itself and the wavelength that has been changed by the phosphor, a lamp that emits white light can be obtained.

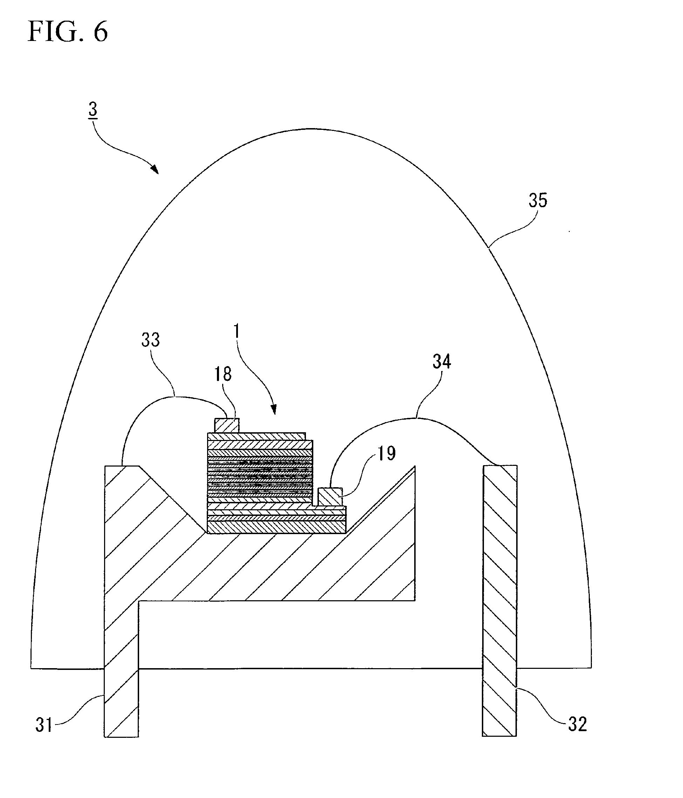

FIG. 6 is a schematic illustration showing one example of a lamp produced using a group-III nitride compound semiconductor light-emitting device according to the present invention. The lamp 3 shown in FIG. 6 is a bullet-shaped lamp, and uses the light-emitting device 1 shown in FIG. 3. As shown in FIG. 6, the light-emitting device 1 is mounted by bonding the positive electrode bonding pad (see reference number 18 in FIG. 3) of the light-emitting device 1 to one of two frames 31 and 32 (the frame 31 in FIG. 6) using a wire 33, and bonding the negative electrode (see reference number 19 in FIG. 4) of the light-emitting device 1 to the other frame 32 using a wire 34. Further, the periphery around the light-emitting device 1 is encapsulated within a mold 35 formed of a transparent resin.

The lamp of the present invention is prepared using the light-emitting device 1 of the present invention, and therefore exhibits excellent light emission properties.
Furthermore, the lamp of the present invention can be used within all manner of applications, including bullet-shaped lamps for general applications, side view lamps for portable backlight applications, and top view lamps used in display equipment.

### EXAMPLES

The present invention is described in more detail below using a series of examples and a comparative example, although the present invention is in no way limited by these examples.

### [Example 1]

A layer formed of AlN was formed as an intermediate layer on the c-plane of a sapphire substrate using a RF sputtering method, and a layer formed of GaN was then formed as a base layer on top of the intermediate layer using a MOCVD method.

### <Formation of Intermediate Layer>

A c-plane sapphire substrate was placed in a sputtering apparatus, the substrate was heated to 500°C inside the chamber of the apparatus, and nitrogen gas was introduced into the chamber at a flow rate of 15 sccm. Subsequently, with the pressure inside the chamber held at 1 Pa, a 500 W high-frequency bias was applied to the substrate side, and the surface of the substrate was cleaned by exposure to nitrogen plasma.
Subsequently, argon gas and nitrogen gas were introduced into the chamber, and the substrate temperature was set to 500°C. High-frequency power of 2,000 W was then applied to the target side, and with the pressure inside the chamber held at 0.5 Pa and under conditions including an argon gas flow rate of 5 sccm and a nitrogen gas flow rate of 15 sccm (nitrogen ratio relative to total gas flow rate: 75%), film formation of an AlN layer on the c-plane of the sapphire substrate was commenced. Following formation of an AlN layer having a single crystal structure and a thickness of 50 nm at a growth rate of 0.08 nm/s, plasma generation was halted, and the substrate temperature was cooled.

Formation of the intermediate layer was performed using a sputtering apparatus having a high-frequency power source and a mechanism for moving the position of the magnet within the target, and a metallic Al target was used as the target. The magnet within the target was set to swing during both the substrate cleaning operation and the film formation.

### <Formation of Base Layer>

The substrate having the AlN layer formed thereon was removed from the sputtering apparatus and placed inside a MOCVD furnace, and a GaN layer was then formed using the method described below.
First, the substrate was placed on a carbon susceptor used for heating that was positioned inside the MOCVD furnace, and following the commencement of nitrogen gas flow into the MOCVD furnace, the heater was activated and the substrate temperature was raised to 1,150°C. Subsequently, once it had been confirmed that the temperature had stabilized, introduction of ammonia gas into the MOCVD furnace was commenced. Hydrogen gas containing trimethyl gallium (TMG) vapor was then supplied to the MOCVD furnace, thereby starting the formation of a GaN layer on the substrate. At this point, the (group-V element)/(group-III element) ratio was adjusted to 6,000. Over a period of approximately one hour, an undoped GaN layer was grown to a film thickness of 2 µm, and supply of the raw materials to the MOCVD furnace was then stopped, thereby halting growth of the layer. Subsequently, power supply to the heater was halted, and the temperature of the substrate was cooled to room temperature. Upon removal, the substrate had a colorless, transparent, mirror-like appearance.

### [Example 2]

In Example 2, with the exception of altering the conditions during cleaning of the substrate surface and the conditions during formation of the intermediate layer, an intermediate layer and a base layer were formed on a substrate in the same manner as Example 1.

### <Formation of Intermediate Layer>

A c-plane sapphire substrate was placed in a sputtering apparatus, the substrate was heated to 750°C inside the chamber of the apparatus, and nitrogen gas was introduced into the chamber at a flow rate of 15 sccm. Subsequently, with the pressure inside the chamber held at 0.08 Pa, a 500 W high-frequency bias was applied to the substrate side, and the surface of the substrate was cleaned by exposure to a nitrogen plasma.
Subsequently, argon gas and nitrogen gas were introduced into the chamber, and the substrate temperature was cooled to 500°C. High-frequency power of 2,000 W was then applied to the target side, and with the pressure inside the chamber held at 0.5 Pa and under conditions including an argon gas flow rate of 15 sccm and a nitrogen gas flow rate of 5 sccm (nitrogen ratio relative to total gas flow rate: 25%), film formation of an AlN layer on the c-plane of the sapphire substrate was commenced. Following formation of an AlN layer formed of a columnar crystal aggregate (polycrystal) having a thickness of 50 nm at a growth rate of 0.08 nm/s, plasma generation was halted, and the substrate temperature was cooled.

Subsequently, formation of a base layer was conducted in the same manner as Example 1. Upon removal from the MOCVD furnace, the substrate had a colorless, transparent, mirror-like appearance.

### [Comparative Example]

Using a MOCVD method, a layer formed of AlN was formed as an intermediate layer on the c-plane of a sapphire substrate as Example 1, and the same method as Example 1 was then used to form a base layer as Example 1 on top of the intermediate layer.

### <Formation of Intermediate Layer and Base Layer>

A c-plane sapphire substrate was placed on a carbon susceptor used for heating that was positioned inside the MOCVD furnace, and following the commencement of nitrogen gas flow into the MOCVD furnace, the heater was activated and the substrate temperature was raised to 1,150°C. Subsequently, once it had been confirmed that the temperature had stabilized, hydrogen gas containing trimethyl aluminum (TMA) vapor was supplied to the MOCVD furnace, thereby starting the deposition of AlN onto the substrate.
Following AlN growth over a period of approximately 10 minutes, a GaN layer was grown in the same manner as Example 1. Upon removal, the substrate had a colorless, transparent, mirror-like appearance.

Test samples were prepared having an intermediate layer and a base layer formed on a substrate in accordance with Example 1 or Example 2 (20 test samples in each case), and 40 test samples were prepared having an intermediate layer and a base layer formed on a substrate in accordance with the comparative example, and the full width at half maximum in rocking curve for the GaN layer was measured for each test sample. Measurement of the full width at half maximum in rocking curve was performed for the (0002) plane and the (10-10) plane.

A CuKα beam was used as the X-ray source, and using an incident beam with a divergence angle of 0.01°, measurement was conducted using a PANalytical X'pert Pro MRD apparatus, manufactured by Spectris plc.
Further, measurement of the rocking curve of the (0002) plane was conducted by identifying the peak corresponding with the (0002) plane, subsequently optimizing the values of 2θ and ω, and then adjusting the Psi value and conducting measurement of the rocking curve in the direction that yielded the maximum peak intensity. Conducting the rocking curve measurement in this manner enabled compensation for any errors caused by differences in the mounting of each substrate within the apparatus or variations in the orientation direction to the substrate for each test sample measured, thereby enabling comparison of the full width at half maximum in rocking curve results for Example 1, Example 2 and the comparative example.

Measurement of the rocking curve of the (10-10) plane was conducted by transmitting X-rays through the in-plane direction under conditions that caused total X-ray reflection. Specifically, if an X-ray beam that diverges in a direction perpendicular to a horizontally positioned measurement sample is irradiated onto the sample in a horizontal direction, then a portion of the beam undergoes total reflection, and those X-rays were used for the measurement. Further, the detector was fixed at the 2θ position corresponding with the (10-10) plane and a φ scan was performed. Then, the 6-fold symmetry peak was measured, and following fixing of the optical system at the peak position that exhibits the maximum intensity, the values of 2θ and ω were optimized, and the rocking curve measurement was performed.

The measurement results for the full width at half maximum in rocking curve values for the GaN base layer of Example 1, Example 2 and the comparative example revealed that for the GaN layer of Example 1 and Example 2, the full width at half maximum in rocking curve of the (0002) plane was approximately 40 arcsec, and the full width at half maximum of the (10-10) plane was within a range from 220 to 250 arcsec.
In contrast, for the GaN layer of the comparative example, the full width at half maximum in rocking curve of the (0002) plane was approximately 200 arcsec, and the full width at half maximum of the (10-10) plane was within a range from 400 to 500 arcsec.

The difference in the results for the full width at half maximum in rocking curve values for the GaN layers of Example 1, Example 2 and the comparative example are thought to be due to the fact that because the AlN layers formed using a sputtering method exhibit superior in-plane uniformity to the intermediate layer formed using a MOCVD method, the orientation of the GaN layer grown on top of the AlN layer improves.

### [Example 3]

As Example 3, a light-emitting device 1 similar to that shown in FIG. 3 and FIG. 4 (refer also to the laminated semiconductor 10 of FIG. 5) was prepared, and a lamp 3 (a light-emitting diode: LED) similar to that shown in FIG. 6 that used the light-emitting device 1 was then prepared.
In this example, first, a RF sputtering method was used to form a single crystal layer formed of AlN as an intermediate layer 12 on the c-plane of a substrate 11 composed of sapphire, and a MOCVD method was then used to form a layer formed of GaN (a group-III nitride compound semiconductor) as a base layer 14a on top of the intermediate layer 12. Each of the other layers was then laminated onto the substrate.

### <Formation of Intermediate Layer>

First, a substrate 11 formed of a 2-inch diameter (0001) c-plane sapphire that had been polished to a mirror surface was placed inside a chamber. A high-frequency sputtering apparatus was used, and a target formed of metallic Al was used as the target.
The substrate 11 was heated to 500°C inside the chamber, and following introduction of nitrogen gas, a high-frequency bias was applied to the substrate 11 side, and the surface of the substrate 11 was cleaned by exposure to nitrogen plasma.

Subsequently, with the temperature of the substrate 11 held at the same level, argon gas and nitrogen gas were introduced into the sputtering apparatus. A high-frequency bias was then applied to the metallic Al target side, and with the pressure inside the chamber maintained at 0.5 Pa, a single crystal intermediate layer 12 formed of AlN was formed on the sapphire substrate 11 under conditions including an Ar gas flow rate of 5 sccm and a nitrogen gas flow rate of 15 sccm. Using a pre-measured film formation rate, treatment was conducted for a specific period of time to form an AlN layer (intermediate layer 12) having a thickness of 40 nm, and the plasma operation was then halted and the temperature of the substrate 11 was cooled.

The X-ray rocking curve (XRC) for the intermediate layer 12 formed on the substrate 11 was then measured using an X-ray measurement apparatus (model: X'pert Pro MRD, manufactured by Spectris plc). The measurement was conducted using a CuKα X-ray beam generation source as the X-ray source. The measurement result revealed that the XRC full width at half maximum for the intermediate layer 12 was 0.1°, which represents an excellent result, and confirmed that the intermediate layer 12 was favorably oriented.

### <Formation of Base Layer>

The substrate 11 having the AlN layer (intermediate layer 12) formed thereon was removed from the sputtering apparatus and transported into a MOCVD apparatus, and a base layer 14a formed of GaN was then formed on the intermediate layer 12 using the procedure described below.
First, the substrate 11 was placed inside the reaction furnace (of the MOCVD apparatus). Subsequently, nitrogen gas was caused to flow through the reaction furnace, and a heater was then activated to raise the substrate temperature from room temperature to 500°C.
With the substrate temperature held at 500°C, NH₃ gas and nitrogen gas were introduced, and the pressure inside the vapor deposition reaction furnace was adjusted to 95 kPa. Subsequently, the substrate temperature was increased to 1,000°C, and the substrate surface was subjected to thermal cleaning. Even following completion of this thermal cleaning, the supply of nitrogen gas to the vapor deposition reaction furnace was continued.

Subsequently, with the supply of ammonia gas continued, the temperature of the substrate was raised to 1,100°C in a hydrogen atmosphere, and the pressure inside the reaction furnace was adjusted to 40 kPa. Once it had been confirmed that the substrate temperature had stabilized at 1,100°C, supply of trimethyl gallium (TMG) to the vapor deposition reaction furnace was commenced, thereby starting the formation of the group-III nitride compound semiconductor (GaN) that constitutes the base layer 14a on top of the intermediate layer 12. Once a GaN layer had been deposited in this manner, the TMG supply valve was switched, and supply of the raw material to the reaction furnace was halted, thereby halting the deposition of the GaN layer.
By following the above procedure, a base layer 14a formed of an undoped GaN with a thickness of 8 µm was formed on top of the intermediate layer 12 formed of a single crystal structure AlN provided on top of the substrate 11.

### <Formation of n-type Contact Layer>

Following the formation of the base layer 14a, the same MOCVD apparatus was used to form the initial layer of an n-type contact layer 14b formed of GaN. During this formation, the n-type contact layer 14b was doped with Si. With the exception of supplying SiH₄ as the Si dopant raw material, crystal growth was conducted under the same conditions as those used for the base layer.

Using the types of procedures described above, the surface of a substrate 11 formed of sapphire was subjected to reverse sputtering, an intermediate layer 12 formed of AlN having a single crystal structure was formed on the substrate 11, and an undoped GaN layer (the n-type base layer 14a) with a film thickness of 8 µm and a Si-doped GaN layer (the initial layer of the n-type contact layer 14b) with a film thickness of 2 µm and having a carrier concentration of 5 × 10¹⁸ cm⁻³ were then formed on the intermediate layer 12. Following film formation, the substrate extracted from the apparatus was colorless and transparent, and the surface of the GaN layer (the initial layer of the n-type contact layer 14b) was a mirror-like surface.

The X-ray rocking curves (XRC) for the Si-doped GaN layer formed in the manner described above were measured using an X-ray measurement apparatus (model: X'pert Pro MRD, manufactured by Spectris plc). The measurements were conducted using a CuKβ X-ray beam generation source as the X-ray source, and were conducted for the symmetrical (0002) plane and the asymmetrical (10-10) plane. Generally, in the case of a group-III nitride compound semiconductor, the full width at half maximum in the XRC of the (0002) plane acts as an indicator of the crystal smoothness (mosaicity), whereas the full width at half maximum in the XRC of the (10-10) plane acts as an indicator of the dislocation density (twist). The measurement results revealed that for the Si-doped GaN layer (n-type contact layer) produced using the production method of the present invention, the full width at half maximum value was 46 arcsec in the measurement of the (0002) plane and 220 arcsec in the measurement of the (10-10) plane.

### <Formation of n-type Cladding Layer and Light-emitting Layer>

Using a MOCVD method, an n-type cladding layer 14c and a light-emitting layer 15 were laminated on top of the n-type contact layer 14b formed using the procedure described above.

### [Formation of n-type Cladding Layer 14c]

The substrate bearing the n-type contact layer 14b deposited using the procedure described above was transported into a MOCVD apparatus, and with ammonia gas flowing through the apparatus and using nitrogen as a carrier gas, the substrate temperature was lowered to 760°C.
While waiting for the temperature inside the furnace to adjust, the SiH₄ supply rate was set. The quantity of SiH₄ required was calculated in advance, and was adjusted so as to yield an electron concentration within the Si-doped layer of 4 × 10¹⁸ cm⁻³. The supply of ammonia to the furnace was continued at the same flow rate.

Subsequently, with ammonia gas flowing through the chamber, SiH₄ gas and vapors of TMI and TEG generated by bubbling were supplied to the furnace, thereby forming a layer of Ga_{0.99}In_{0.01}N with a thickness of 1.7 nm, and a layer of GaN with a thickness of 1.7 nm. After repeating 19 cycles of this type of film formation treatment, a layer of Ga_{0.99}In_{0.01}N with a thickness of 1.7 nm was finally formed. Further, while this treatment was being conducted, the flow of SiH₄ was continued. This enabled the formation of an n-type cladding layer 14c composed of a superlattice structure of Si-doped Ga_{0.99}In_{0.01}N and GaN.

### [Formation of Light-emitting Layer]

The light-emitting layer 15 is composed of a barrier layer 15a formed of GaN and a well layer 15b formed of Ga_{0.92}In_{0.08}N, and has a multiple quantum well structure. In order to form this light-emitting layer 15, the barrier layer 15a is first formed on the n-type cladding layer 14c formed from a superlattice structure of Si-doped GaInN and GaN, and the well layer 15b formed of Ga_{0.92}In_{0.08}N is then formed on top of this barrier layer 15a. In this example, this type of lamination procedure was repeated six times, and a seventh barrier layer 15a was then formed on top of the sixth laminated well layer 15b, thereby forming a structure in which a barrier layer 15a was positioned at both sides of the light-emitting layer 15 having a multiple quantum well structure (It should be noted that FIG. 3 and FIG. 5 show an example in which six barrier layers 15a and five well layers 15b are formed).

First, with the substrate temperature held at 760°C, supply of TEG and SiH₄ to the furnace was commenced, an initial barrier layer formed of Si-doped GaN with a thickness of 0.8 nm was formed over a predetermined time period, and the supply of TEG and SiH₄ was then halted. Subsequently, the temperature of the susceptor was raised to 920°C. Supply of TEG and SiH₄ to the furnace was then restarted, and with the substrate temperature held at 920°C, an intermediate barrier layer with a thickness of 1.7 nm was deposited, and the supply of TEG and SiH₄ to the furnace was once again halted. Subsequently, the susceptor temperature was lowered to 760°C, supply of TEG and SiH₄ was again restarted, and following formation of a final barrier layer with a thickness of 3.5 nm, the supply of TEG and SiH₄ was once again halted, completing formation of the GaN barrier layer. By using this type of 3-stage film formation process, a Si-doped GaN barrier layer (the barrier layer 15a) composed of an initial barrier layer, an intermediate barrier layer and a final barrier layer was formed with a total film thickness of 6 nm. The quantity of SiH₄ was adjusted to yield a Si concentration of 1 × 10¹⁷ cm⁻³.

Following formation of the GaN barrier layer described above (the barrier layer 15a), TEG and TMI were supplied to the furnace, and film formation of a well layer was conducted, thereby forming a Ga_{0.92}In_{0.08}N layer with a thickness of 3 nm (the well layer 15b).
Then, following completion of the formation of the well layer 15b formed of Ga_{0.92}In_{0.08}N, the setting for the TEG supply rate was altered, supply of TEG and SiH₄ was restarted, and a second barrier layer 15a was formed.

By repeating the above procedure six times, six barrier layers 15a formed of Si-doped GaN and six well layers 15b formed of Ga_{0.92}In_{0.08}N were formed.

Following formation of the sixth well layer 15b formed of Ga_{0.92}In_{0.08}N, a seventh barrier layer 15a was formed. In the formation process for this seventh barrier layer, the supply of SiH₄ was first halted, an initial barrier layer formed of undoped GaN was formed, the substrate temperature was then raised to 920°C while the supply of TEG to the furnace was continued, an intermediate barrier layer was formed over a prescribed time period at a substrate temperature of 920°C, and the supply of TEG to the furnace was then halted. Subsequently, the substrate temperature was cooled to 760°C, the supply of TEG was restarted, and following formation of a final barrier layer, the supply of TEG was once again halted, completing formation of the GaN barrier layer. By using this formation process, an undoped GaN barrier layer composed of three layers, namely, the initial barrier layer, the intermediate barrier layer and the final barrier layer, was formed with a total film thickness of 4 nm (refer to the uppermost barrier layer 15a of the light-emitting layer 15 shown in FIG. 3).

By using the procedure outlined above, a light-emitting layer 15 was formed with a multiple quantum well structure containing well layers of non-uniform thickness (equivalent to the first to fifth well layers 15b from the n-type semiconductor layer 14 side in FIG. 3) and a well layer having a uniform thickness (equivalent to the sixth well layer 15b from the n-type semiconductor layer 14 side in FIG. 3).

### <Formation of p-type Semiconductor Layers>

Following each of the processes described above, the same MOCVD apparatus was used to form a p-type cladding layer 16a having a superlattice structure formed of four layers of undoped Al_{0.06}Ga_{0.94}N and three layers of Mg-doped GaN, and then a p-type contact layer 16b formed of a Mg-doped GaN with a thickness of 200 nm, thereby completing the p-type semiconductor layer 16.

First, the substrate temperature was raised to 975°C while NH₃ gas was supplied to the chamber, and the carrier gas was then switched from nitrogen to hydrogen at this temperature. Subsequently, the substrate temperature was increased to 1,050°C. TMG and TMA were then supplied to the furnace, thereby forming a 2.5 nm layer of undoped Al_{0.06}Ga_{0.94}N. Subsequently, with no time interval allowed, the TMA valve was closed and a Cp₂Mg valve was opened, thereby forming a Mg-doped GaN layer with a thickness of 2.5 nm.
By repeating the above type of operation three times, and then forming an undoped Al_{0.06}Ga_{0.94}N layer finally, a p-type cladding layer 16a having a superlattice structure was formed.

Subsequently, only Cp₂Mg and TMG were supplied to the furnace, and a p-type contact layer 16b formed of p-type GaN with a thickness of 200 nm was formed.

The epitaxial wafer for an LED prepared in the manner described above has a laminated structure in which an AlN layer (the intermediate layer 12) having a single crystal structure is first formed on a substrate 11 composed of sapphire having a c-plane, and sequentially thereafter are formed, from the substrate 11 side, an 8 µm undoped GaN layer (the base layer 14a), an n-type contact layer 14b composed of a Si-doped GaN initial layer of 2 µm having an electron concentration of 5 × 10¹⁸ cm⁻³ and a Si-doped GaN second layer of 200 nm, a cladding layer (the n-type cladding layer 14c) having a Si concentration of 4 × 10¹⁸ cm⁻³ and having a superlattice structure formed of 20 layers of 1.7 nm Ga_{0.99}In_{0.01}N and 19 layers of 1.7 nm GaN, a multiple quantum well structure (the light-emitting layer 15) that begins with a GaN barrier layer and ends with a GaN barrier layer, and is composed of six Si-doped GaN barrier layers (the barrier layers 15a) each having a layer thickness of 6 nm, six layers of undoped Ga_{0.92}In_{0.08}N well layers (the well layers 15b) each having a layer thickness of 3 nm, and an uppermost barrier layer containing a final barrier layer formed of undoped GaN (equivalent to the uppermost barrier layer 15a within the light-emitting layer 15 shown in FIG. 3), and a p-type semiconductor layer 16 composed of a p-type cladding layer 16a formed of four layers of undoped Al_{0.06}Ga_{0.94}N of thickness 2.5 nm and three layers of Mg-doped Al_{0.01}Ga_{0.99}N of thickness 2.5 nm and having a superlattice structure, and a p-type contact layer 16b formed of Mg-doped GaN with a thickness of 200 nm.

### [Example 4]

Using the same process for forming a light-emitting layer 15 as that described above in Example 3, but with the exception of forming the last of the seven barrier layers 15a without doping, an epitaxial wafer for an LED containing an n-type semiconductor layer 14, a light-emitting layer 15 and a p-type semiconductor layer 16 laminated in a sequential manner was produced using the same operational procedure as Example 3 (It should be noted that FIG. 3 and FIG. 5 show an example in which six barrier layers 15a and five well layers 15b are formed).

### [Example 5]

With the exception of conducting the steps described above in Example 3 and Example 4 for forming the p-type semiconductor layer 16 on top of the light-emitting layer 15 via the type of procedure described below, an epitaxial wafer for an LED was produced using the same operational procedure as Example 3.
In this example, the same MOCVD apparatus as that used in forming the light-emitting layer 15 was used, and a p-type semiconductor layer 16 was formed on top of the light-emitting layer 15 by appropriately adjusting the supply rates of TMG, TMA and Cp₂Mg to form a p-type cladding layer 16a having a superlattice structure formed of four layers of undoped Al_{0.06}Ga_{0.94}N and three layers of Mg-doped Al_{0.01}Ga_{0.99}, and then forming a p-type contact layer 16b formed of a Mg-doped GaN with thickness of 200 nm on top of the p-type cladding layer 16a.

### [Example 6]

Each epitaxial wafer for an LED obtained using the methods described in the above examples was used to prepare an LED.
In other words, a conventional photolithography technique was used to form a translucent positive electrode 17 composed of IZO on the surface of the Mg-doped GaN layer (the p-type contact layer 16b) of the epitaxial wafer, and a positive electrode bonding pad 18 (a p-electrode bonding pad) was formed by sequentially laminating chromium, titanium and gold onto the translucent positive electrode 17, thus completing the p-side electrode. The wafer was then subjected to dry etching to expose a region of the n-type contact layer 14b for forming the n-side electrode (the negative electrode), and the negative electrode 19 (the n-side electrode) was then formed by sequentially laminating three layers, namely Cr, Ti and Au, onto this exposed region 14d. Using this procedure, electrodes having the shapes shown in FIG. 3 and FIG. 4 were formed.

The underside of the sapphire substrate 11 within the wafer comprising the p-side and n-side electrodes formed via the procedure outlined above was then ground or polished to form a mirror-like surface. The wafer was then cut into square chips having a side length of 350 µm, forming the type of light-emitting device 1 shown in FIG. 3 and FIG. 4. The chip was then positioned on a lead frame with each electrode facing upwards, and gold wiring was used to connect the electrodes to the lead frame, thus forming a light-emitting diode (LED) (see the lamp 3 in FIG. 6). When a forward current was caused to flow between the p-side and n-side electrodes of the thus prepared light-emitting diode, the forward voltage at a current of 20 mA was 3.1 V. Further, when the state of light emission was observed through the p-side translucent positive electrode 17, the emission wavelength was 460 nm and the light emission output was 20 mW. In the produced light-emitting diodes, these types of light emission properties were obtained with minimal variation across almost the entire surface of the wafer.

### INDUSTRIAL APPLICABILITY

A group-III nitride compound semiconductor light-emitting device obtained in the present invention has a group-III nitride compound semiconductor layer of superior crystallinity, and exhibits excellent light emission properties. Accordingly, semiconductor devices such as light-emitting diodes, laser diodes or electronic devices and the like that have excellent light emission properties can be produced.

## Claims

1. A group-III nitride compound semiconductor device, comprising:
a substrate,
an intermediate layer provided on said substrate, and
a base layer provided on said intermediate layer, in which a full width at half maximum in rocking curve of a (0002) plane is 100 arcsec or lower, and a full width at half maximum in rocking curve of a (10-10) plane is 300 arcsec or lower.

2. The group-III nitride compound semiconductor device according to claim 1, wherein the full width at half maximum in rocking curve of said (0002) plane is 50 arcsec or lower and the full width at half maximum in rocking curve of said (10-10) plane is 250 arcsec or lower.

3. The group-III nitride compound semiconductor device according to claim 1, wherein said substrate is sapphire.

4. The group-III nitride compound semiconductor device according to claim 3, wherein said intermediate layer is formed on a c-plane of said sapphire substrate.

5. The group-III nitride compound semiconductor device according to claim 1, wherein said intermediate layer is formed of AlₓGa₁₋ₓN (0≤x≤1).

6. The group-III nitride compound semiconductor device according to claim 1, wherein said intermediate layer is formed of AlN.

7. The group-III nitride compound semiconductor device according to claim 1, wherein said base layer is formed of AlGaN.

8. The group-III nitride compound semiconductor device according to claim 1, wherein said base layer is formed of GaN.

9. A group-III nitride compound semiconductor light-emitting device, comprising a group-III nitride compound semiconductor device according to claim 1, and a semiconductor layer prepared by sequentially laminating an n-type semiconductor layer, a light-emitting layer and a p-type semiconductor layer, wherein
said semiconductor layer is formed on said base layer of said group-III nitride compound semiconductor device.

10. The group-III nitride compound semiconductor light-emitting device according to claim 9, wherein said n-type semiconductor layer comprises an n-type cladding layer, said p-type semiconductor layer comprises a p-type cladding layer, and said n-type cladding layer and/or said p-type cladding layer comprises at least a superlattice structure.

11. A production method of a group-III nitride compound semiconductor device according to claim 1, said method comprising:
forming said intermediate layer by using a sputtering method.

12. The production method of a group-III nitride compound semiconductor device according to claim 11, further comprising forming said base layer by using a MOCVD method.

13. A production method of a group-III nitride compound semiconductor light-emitting device, said method comprising:
forming a semiconductor layer by sequentially laminating an n-type semiconductor layer, a light-emitting layer and a p-type semiconductor layer on top of said base layer of a group-III nitride compound semiconductor device according to claim 1, and
forming said intermediate layer by using a sputtering method.

14. The production method of a group-III nitride compound semiconductor light-emitting device according to claim 13, further comprising forming said base layer by using a MOCVD method.

15. A group-III nitride compound semiconductor device produced by the production method according to claim 11.

16. A group-III nitride compound semiconductor light-emitting device produced by the production method according to claim 13.

17. A lamp that uses the group-III nitride compound semiconductor light-emitting device according to claim 9.

18. A lamp that uses the group-III nitride compound semiconductor light-emitting device according to claim 10.

19. A lamp that uses the group-III nitride compound semiconductor light-emitting device according to claim 16.
